(19) Europäisches Patentamt
European Patent Office
Office européen des brevets

(11) **EP 2 189 897 B1**

(12) **EUROPÄISCHE PATENTSCHRIFT**

(45) Veröffentlichungstag und Bekanntmachung des Hinweises auf die Patenterteilung:
**24.04.2013 Patentblatt 2013/17**

(51) Int Cl.:
*G06F 7/487* *(2006.01)*   *G06F 7/527* *(2006.01)*
*G06F 7/499* *(2006.01)*   *H03M 7/24* *(2006.01)*

(21) Anmeldenummer: 08020118.9

(22) Anmeldetag: **19.11.2008**

(54) **Multiplikation einer ganzen Zahl mit einer Gleitkommazahl**

Multiplication of an integer with a floating-point number

Multiplication d'un nombre entier avec un nombre à virgule flottante

(84) Benannte Vertragsstaaten:
**DE FR GB**

(43) Veröffentlichungstag der Anmeldung:
**26.05.2010 Patentblatt 2010/21**

(73) Patentinhaber: **VEGA Grieshaber KG**
**77709 Wolfach (DE)**

(72) Erfinder: **Kopp, Manfred**
**77709 Wolfach (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
**EP-A- 0 278 529    DE-A1-102006 013 827**
**JP-A- 61 049 234    US-B1- 6 233 595**

• **BEHROOZ PARHAMI: "Computer Arithmetic: Algorithms and Hardware Designs" 2000, OXFORD UNIVERSITY PRESS , NEW YORK, NY, USA 239790 , XP002189675 ISBN: 978-0-19-512583-2 Seiten 143-153, 200-203 * Seite 147; Abbildungen 9.4,9.6 ***
• **G. MARIN ET AL: "Application Insight Through Performance Modeling" IPCCC 2007, April 2007 (2007-04), Seiten 65-74, XP031086858 IEEE, PISCATAWAY, NJ, USA ISBN: 978-1-4244-1137-5**
• **"16-BIT FLOATING-POINT MATH IN AN 8-BIT MICROPROCESSOR", IBM TECHNICAL DISCLOSURE BULLETIN, vol. 32, no. 7, December 1989 (1989-12), pages 222-223, XP000078077, Armonk, NY, USA ISSN: 0018-8689**

**Beschreibung**

Die Erfindung bezieht sich auf ein Verfahren zum Ansteuern einer Füllstandsmessgeräts.

Füllstandsmessgeräte erfassen Messwerte, welche auf einen Füllstand in einem Behältnis bezogen sind. Neben einem Sensor zum Erfassen der Messwerte weisen solche Füllstandsmessgeräte oftmals auch Rechner auf. Diese dienen dazu, einen durch einen Sensor erfassten Messwert mit einem Anpassungsfaktor zu multiplizieren, um Sensoreinflüsse oder Geräteeinflüsse beim Erfassen des Messwerts auszugleichen. Oftmals wird der eigentliche Messwert über einen Analog-Digital-Wandler als ganze Zahl angelegt, während der Anpassungsfaktor eine reelle Zahl in Form einer Gleitkommazahl ist. Entsprechend muss der Rechner eine ganze Zahl mit einer Gleitkommazahl zu einem Ergebnis multiplizieren.

Auf einem Rechner, insbesondere Mikrorechner mit einem sehr kleinem Speicher eines solchen Füllstandsmessgeräts ist oftmals eine ganze Zahl, darstellbar z.B. als Datentyp short int, int bzw. (long) int in C oder als Datentyp INTEGER bzw. LON-GINT in Pascal, mit einer Gleitkommazahl, z.B. 1,2288, darstellbar z.B. als Datentyp float in C oder als Datentyp REAL in Pascal, zu multiplizieren, wobei als Ergebnis wieder eine ganze Zahl entstehen soll. Diese Operation ist z.B. erforderlich, wenn ein gemessener Rohwert mit einem Faktor multipliziert werden muss, um einen genauen Messwert zu erhalten. Dabei werden Rechenoperationen für Gleitkommazahlen anstelle von Multiplikationen und Divisionen für ganze Zahlen verwendet, da der Mikrorechner diese Rechenoperationen nicht im Befehlssatz eingebaut hat und sie deshalb als Bibliotheksfunktionen aufgerufen werden müssen. Diese Bibliotheksfunktionen benötigen viele Befehle des Befehlssatzes des Mikrorechners und verbrauchen deshalb erstens viel Speicher, der auf dem Mikrorechner oft nicht zur Verfügung steht, und zweitens viel Rechenzeit, was einen erhöhten Strombedarf bedeutet, da der Mikrorechner in dieser Zeit keinen Stromspar-Modus benutzen kann. Außerdem kann es bedeuten, dass die gestellte technische Aufgabe nur gelöst werden kann, wenn die Rechenzeit sehr klein ist und die maximale Geschwindigkeit des Mikrorechners, insbesondere dessen Taktfrequenz, aus technischen Gründen nicht erhöht werden kann. Zulässige Grenzwerte der Bauteile des Mikrorechners und Strombedarf je nach Taktfrequenz begrenzen daher die Einsetzbarkeit von Mikrorechnern in Sensoren und Füllstandsmessgeräten.

Derzeit wird eine ganze Zahl mit einer Gleitkommazahl auf 2 Arten multipliziert. Gemäß der ersten Art wird die ganze Zahl mit einer zweiten ganzen Zahl multipliziert und anschließend das Produkt durch eine dritte ganze Zahl dividiert, wobei der Quotient der zweiten und der dritten ganzen Zahl möglichst genau der reellen Zahl entsprechen muss. Gemäß der zweiten Art wird die ganze Zahl in eine Gleitkommazahl gewandelt, z.B. 89 in 89,0, und eine Rechenoperation für die Multiplikation zweier Gleitkommazahlen benutzt. Anschließend wird das Ergebnis zurück in eine ganze Zahl gewandelt.

Aus der US 6233595 B1 ist ein Verfahren zur Multiplikation zwischen einer ganzen Zahl und einer Gleitkommazahl bekannt, bei dem entweder eine Standard-Multiplikation von zwei Gleitkommazahlen erfolgt oder durch Kopieren der Mantisse der Gleitkommazahl und Manipulation von deren Exponenten, falls der ganzzählige Operand als eine Exponentialdarstellung bezogen auf den Basis zwei darstellbar ist, bekannt.

Aus der JP 61049234 A ist ein Hardware-Multiplikation für Gleitkommazahlen bekannt, mit dem Zwei Gleitkommazahlen hardwaremäßig multipliziert werden können.

Aus dem neunten Kapitel des Buchs "Computer Arithmetic: Algorithms and Hardware Designs" von Behrooz Parhami, Oxford University Press, New York, NY, USA 239790, XP 002189675 sind verschiedene Verfahren zur Multiplikation von K-Bitoperanden bekannt.

Aus der EP 0278529 A ist ein Hardware-Multiplikatorschaltkreis bekannt, mit dem eine Multiplikation der Inhalte eines Multiplikator - und eines Multiplikandenregisters erzielt wird.

Aus dem Artikel "Application Insight Through Performance Modeling" von G. Martin Et All, IPCC 2007, April 2007, Seiten 64-74, XP 031086858 ist der Gedanke bekannt, Multiplikation und Division von ganzzahligen Operanden durch Übersetzung der Operanten in ein Gleitkommaformat und Ausführung der äquivalenten Gleitkomma-Operationen durchzuführen.

Die DE 10 2006 013 827 A1 offenbart ein Verfahren zum Ansteuern eines Feldgeräts, wie zum Beispiel eines Füllstandsmessgeräts; zur Multiplikation einer ersten Zahl mit einer zweiten Zahl zu einem Ergebnis der Multiplikation. Das Feldgerät weist des Weiteren

-　einen Messwerteingang zum Anlegen eines Messwerts,
-　zumindest einen ersten Speicherbereich zum Bereitstellen eines Anpassungsfaktors und
-　einen Rechner (μP) zur Messwertverarbeitung auf.

Für das Rechnen mit Gleitkommazahlen wird gegenwärtig ein spezielles Kodierungsverfahren für Gleitkommazahlen in Mikrorechnern angewandt. Basis für das Verfahren ist die Tatsache, dass man eine Gleitkommazahl x auch durch eine mathematische Reihe annähern kann. Diese Methode wird z.B. bei der Darstellung von Gleitkommazahlen im IEEE-754 Floating-Point-Format angewendet. Da Mikrorechner sehr gut mit Zahlen im dualen Zahlensystem arbeiten können, wird die Reihe der negativen Zweierpotenzen verwendet. Eine beliebige (reelle) Zahl x lässt sich dabei näherungsweise darstellen als

$$x \approx (-1)^s \cdot 2^e \left( m_0 + m_1 2^{-1} + m_2 2^{-2} + m_3 2^{-3} + \ldots + m_p 2^{-P} \right) = s \cdot 2^e \sum^{P} m_n 2^{-n} \, ,$$

wobei die Koeffizienten der Mantisse $m_0 .. m_p$ 0 oder 1 sein können und das Vorzeichen s = 0 bei einer positiven bzw. s = 1 bei einer negativen Zahl ist. Der Exponent in dieser Binär-Exponentialschreibweise ist e, womit nicht die Eulersche Zahl gemeint ist.

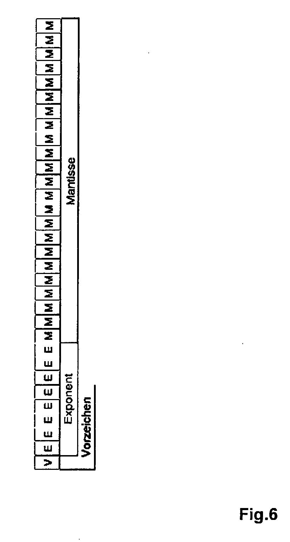

Fig. 6 zeigt das Speicherformat einer Gleitkommazahl im IEEE-754 32 Bit Floating-Point-Format, wie sie üblicherweise zur Speicherung zwischen mehreren Verarbeitungsschritten innerhalb von Mikrorechnern und Übertragung zwischen Mikrorechnern und Datenträgern oder zwischen mehreren Mikrorechnern kodiert wird.

Im Mikrorechner wird eine Zahl im IEEE-754 Floating-Point-Format mit 32 Bit gespeichert mit einem Bit des Vorzeichens S, 8 Bit des Exponenten E und 23 Bit der Mantisse M. Das hochwertigste Bit (most-significant-bit, MSB) der Mantisse M und des Exponenten E steht dabei jeweils ganz links, das geringwertigste (least-significant-bit, LSB) ganz rechts. Es gibt weitere Varianten von IEEE-754-Formaten für geringere oder höhere Genauigkeiten. Außerdem gibt es Darstellungsformen für Binär kodierte Zahlen, bei denen das MSB ganz rechts steht. Verwendet ein Mikrorechner eine solche Darstellungsform auch intern für seine Register und Recheneinheit (ALU), so kehren sich auch die Richtungen für Schiebeoperationen zur Multiplikation mit bzw. Division durch 2 entsprechend um. Üblicherweise wird allerdings die Darstellungsform mit MSB ganz links angenommen, selbst wenn der Mikrorechner Zahlen, die aus mehreren Bytes zusammengesetzt sind, im Little-Endian-Format verarbeitet, was bedeutet, dass die Wertigkeit der einzelnen Bytes (Gruppen von 8 Bits) entsprechend der Speicheradresse zunimmt. Nach Lage der Speicheradressen steht bei Mikrorechnern mit Little-Endian-Format das geringwertigste Byte also ganz links, wenn man Speicheradressen von links nach rechts als aufsteigend annimmt. Im Gegensatz dazu steht bei Mikrorechnern mit Big-Endian-Format das geringwertigste Byte ganz rechts und die Wertigkeit nimmt entsprechend der Speicheradresse ab. Dieser Unterschied hat jedoch nur Auswirkungen, wenn der Mikrorechner mehrere Operationen und Speicherzugriffe benötigt, um größere Datenwortbreiten als die Wortbreite seiner Register und des Datenspeichers verarbeiten zu können.

Die Mantisse M jeder von 0 verschiedenen Zahl in dieser Darstellung kann durch Multiplizieren mit 2, dies entspricht einem Linksschieben der Mantisse um ein Bit, und gleichzeitiges Vermindern des Exponent um 1 je Verschiebung solange verändert werden, wie der Koeffizient $m_0$ = 0 ist und bis er erstmals 1 wird, ohne dass sich am Wert der Zahl etwas ändert. Beträgt dabei die Anzahl der Verschiebungen n, so wird der Exponent dabei um n vermindert und der Faktor $2^e$ vor der Mantisse durch $2^n$ dividiert und die Mantisse gleichzeitig mit $2^n$ multipliziert. Diese Möglichkeit wird beim IEEE-754 Floating-Point-Format immer angewendet. Eine Gleitkommazahl in einer solchen Form heißt dann ‚normalisiert'.

Da bei einer ‚normalisierten Gleitkommazahl' der 1. Koeffizient bzw. das höchste Bit, auch bezeichnet als MSB, der Mantisse immer 1 ist, braucht man diese 1 nicht mitspeichern und gewinnt dabei 1 zusätzliches Bit für die Auflösung bzw. die Genauigkeit p.

Das im IEEE-754 Floating-Point-Format nicht gespeicherte höchste Bit der Mantisse wird deshalb auch als verstecktes Bit (engl. hidden-bit) bezeichnet.

Es gibt jedoch auch andere Formate für Gleitkommazahlen, bei denen das höchste Bit der Mantisse mitgespeichert wird. Insbesondere bei Berechnungen mit Gleitkommazahlen muss das höchste Bit, das ja den Wert 1 hat, wieder ergänzt werden, damit ein korrektes Rechenergebnis entsteht.

Eine weitere Besonderheit ergibt sich dadurch, dass der Exponent e mit einer Verschiebung (engl. bias B) gespeichert wird, so dass e = E - B bzw. E = e + B gilt mit E als dem gespeicherten Exponenten. Als bias wird dabei $2^{r-1}-1$ verwendet, wenn r die Auflösung bzw. die Bit-Anzahl des Exponent ist. So ist B = 127, wenn r = 8 ist.

Die Mantisse m einer ‚normalisierten' Gleitkommazahl liegt immer genau im Intervall 1,0 <= m < 2,0. Dies gilt bei Notation als Binärzahl, Zahlenbasis 2. Allgemein formuliert liegt die Mantisse m einer ‚normalisierten' Gleitkommazahl immer genau im Intervall 1,0 <= m < N, wenn N die zur Notation verwendete Zahlenbasis ist. Deshalb wird für die Darstellung der Zahl 0 im IEEE-754 Floating-Point-Format eine gesonderte Schreibweise benötigt. Eine Zahl ist danach genau dann 0, wenn Mantisse m und Exponent e gleichzeitig 0 sind.

Daraus folgt dass der Exponent E der Zahl 1,0 als 127 gespeichert wird gemäß $2^{127-127} \times 1,00 \ldots = 2^0 \times 1,00 \ldots$ und der Exponent der Zahl 0,0 als 0 gemäß $2^{0-127} \times 1,00 \ldots = 2^{-127} \times 1,00 \ldots$. Die 1,00.. in der Mantisse kommen dabei von der implizit immer angenommen 1 im nicht gespeicherten Bit $m_0$ der Mantisse bei einer normalisierten Zahl. Allerdings ist bei Berechnungen $2^{-127}$ praktisch gleich 0 und außerdem kann für den Fall dass E=0 und M=1,0, d.h. alle gespeicherten Bits von M sind 0, eine Sonderbehandlung durchgeführt werden.

Nachteilhaft ist bei solchen Lösungen des Standes der Technik, im Fall ganzer Zahlen, dass die Rechenoperation für Ganzzahl-Division benötigt wird. Diese Operation benötigt viel Programm- und Datenspeicher und Rechenzeit, sofern der Mikrorechner diese Rechenoperation nicht in seinem Befehlssatz eingebaut hat. Das Produkt der ganzen Zahl und zweiten ganzen Zahl kann dabei den Zahlenbereich der ganzen Zahlen verlassen, z.B. 16Bit, und Ganzzahl-Operationen mit vergrößertem Zahlenbereich, z.B. 32 Bit, erforderlich machen.

Nachteilhaft bei Gleitkommazahlen ist, dass die Rechenoperation für die Multiplikation zweier Gleitkommazahlen erforderlich ist. Außerdem müssen Umwandlungsoperationen ganze Zahl zu Gleitkommazahl und Gleitkommazahl zu ganzer Zahl durchgeführt werden. Alle drei Operationen benötigen viel Programm- und Datenspeicher und Rechenzeit, sofern der Mikrorechner diese Rechenoperationen nicht in seinem Befehlssatz eingebaut hat. Außerdem ist der Stromverbrauch zur Berechnung hoch.

Die Aufgabe der Erfindung besteht darin, ein Verfahren zum Ansteuern eines Füllstandsmessgeräts zur Multiplikation einer ganzen Zahl mit einer Gleitkommazahl bereitzustellen, welche mit geringem Speicherbedarf, kurzer Rechenzeit und damit mit ggf. geringem Strombedarf auskommen. Es sollen keine Rechenoperationen für Gleitkommazahl und keine Division für ganze Zahlen verwendet werden.

Diese Aufgabe wird gelöst durch ein Verfahren zum Ansteuern eines Füllstandsmessgeräts zur Multiplikation einer ganze Zahl mit einer Gleitkommazahl gemäß Patentanspruch 1. Vorteilhafte Ausgestaltungen sind Gegenstand von abhängigen Ansprüchen.

Ausgegangen wird somit von einem Füllstandsmessgerät mit einem Messwerteingang zum Anlegen eines Messwerts, zumindest einem ersten Speicherbereich zum Bereitstellen eines Anpassungsfaktors und einem Rechner, der ausgelegt und/oder gesteuert ist zur Multiplikation einer ersten ganzen Zahl mit einer Gleitkommazahl zu einem Ergebnis der Multiplikation, wobei die erste ganze Zahl entweder einerseits dem angelegten Messwert oder einem anderen Messwert oder andererseits dem bereitgestellten Anpassungsfaktor entspricht und die Gleitkommazahl dem Anpassungsfaktor entspricht. Üblicherweise entspricht dabei die ganze Zahl dem Messwert und die Gleitkommazahl dem Anpassungsfaktor. Vorteilhaft wird der Sensor, das Bediengerät, das Kommunikationsgerät oder das Füllstandsmessgerät dadurch, dass der Rechner einen zweiten Speicherbereich zum Speichern der Gleitkommazahl in einem Format einer zweiten ganzen Zahl, insbesondere mit zugehörigem Exponenten und Vorzeichen, aufweist und der Rechner ausgelegt und/oder gesteuert ist, eine Multiplikation der ersten ganzen Zahl und der zweiten ganzen Zahl durchzuführen.

Der Rechner weist insbesondere eine Logik auf, die ausgelegt und/oder gesteuert ist zum Umsetzen der Gleitkommazahl in eine exponentielle, insbesondere binäre Zahl mit einer Stelle für das Vorzeichen und einer Vielzahl von Stellen für einen Exponenten und einer Vielzahl von Stellen für eine Mantisse als die zweite ganze Zahl und zum Verwerfen eine von einer Präzision der Mantisse und von dem Exponenten abhängige Anzahl von Stellen des Multiplikationsergebnisses nach der Multiplikation.

Der erste Speicherbereich und eine den zweiten Speicherbereich ansteuernde Logik des Rechners sind bevorzugt ausgelegt, die zweite ganze Zahl als eine binäre Zahl mit einer Vielzahl von Stellen für einen Exponenten und einer Vielzahl von Stellen für eine Mantisse zu speichern.

Ein Berechnungsspeicherbereich ist bevorzugt als ein Register ausgelegt oder ansteuerbar und der Rechner weist bevorzugt eine Logik auf, die ausgelegt und/oder gesteuert ist zum Durchführen der Multiplikation mit einer Zweierpotenz und/oder einer Division durch eine Zweierpotenz durch eine bitweise Verschiebung eines Inhalts des Berechnungsspeicherbereichs. Eine solche Anordnung ermöglicht, zwei ganze Zahlen, von welchen die zweite ganze Zahl eine exponentielle, insbesondere binäre Darstellung der Mantisse einer Gleitkommazahl repräsentiert, durch einfache Verschiebeoperationen und Additionen zu multiplizieren bzw. zu dividieren. Dabei sind keine mathematisch aufwendigen Multiplikations- bzw. Divisionsalgorithmen erforderlich. Letztendlich können so eine Gleitkommazahl und eine ganze Zahl durch Einsatz von nur Additionen und Verschiebungen multipliziert werden, um eine ganze Zahl als Ergebnis der Multiplikation auszugeben.

Eigenständig bevorzugt wird ein Verfahren zum Ansteuern eines Sensor- oder Bediengerät- oder Kommunikationsgerät- oder Füllstandsmessgerät-Rechners zur Multiplikation einer ganzen Zahl mit einer Gleitkommazahl zu einem Ergebnis der Multiplikation, wobei die erste Zahl als ganze Zahl entweder dem angelegten oder einem anderen Messwert oder einem bereitgestellten Anpassungsfaktor entspricht und die zweite Zahl als Gleitkommazahl dem anderen von dem Messwert oder dem bereitgestellten Anpassungsfaktor entspricht und wobei die Gleitkommazahl in einer Darstellungsform einer zweiten ganzen Zahl bereitgestellt wird und eine Multiplikation der ersten ganzen Zahl und der zweiten ganzen Zahl durchgeführt wird.

Als die zweite ganze Zahl wird bevorzugt die Gleitkommazahl in eine exponentielle, insbesondere binäre Zahl mit einer Stelle für ein Vorzeichen und einer Vielzahl von Stellen für einen Exponenten und einer Vielzahl von Stellen für eine Mantisse umgesetzt. Insbesondere wird dabei eine von einer Präzision der Mantisse und von dem Exponenten abhängige Anzahl von Stellen des Multiplikationsergebnisses nach der Multiplikation verworfen.

Zum Durchführen der Multiplikation wird bevorzugt wiederholt ein Addieren und eine bitweise Verschiebung eines Inhalts eines Berechnungsspeicherbereichs oder ein dementsprechendes Auslesen des Inhalts des Berechnungsspeicherbereichs durchgeführt.

Zum Multiplizieren kann ein Ganzzahl-Multiplikationsbefehl eines Rechners durchgeführt werden, wobei eine Mantisse der Gleitkommazahl, insbesondere der Mantisse einer Gleitkommazahl im IEEE-754 Floating-Point-Format, als ganze Zahl interpretiert und mit der ersten ganzen Zahl multipliziert wird, woraufhin nach der Multiplikation entsprechend einem Exponenten mit e Bit und einer Präzision p der Mantisse p-e Bits verworfen werden.

Eine Schleife aus Additionen und Verschiebungen wird bevorzugt vorzeitig nach einer Anzahl von K Schleifendurchläufen beendet, sobald alle weiteren Koeffizienten der Mantisse gleich 0 sind, woraufhin nach der Multiplikation entsprechend einem Exponenten e und einer Präzision p der Mantisse K-e Bits Bits verworfen werden, wobei die Anzahl K der Schleifendurchläufe maximal so groß wie die Präzision p ist. Dieses vorzeitige Beenden der Ablauf- bzw. Programmschleife ist sinnvoll, da nur noch der Wert 0 zur Summe addiert werden würde.

Zum Durchführen einer Division durch eine Zweierpotenz kann eine bitweise Verschiebung eines Inhalts eines Berechnungsspeicherbereichs oder ein dementsprechendes Auslesen des Inhalts des Berechnungsspeicherbereichs durchgeführt werden.

Die zweite ganze Zahl, insbesondere als eine Gleitkommazahl im IEEE-754 Floating-Point-Format, kann mit dem zugehörigen Exponenten und dem zugehörigen Vorzeichen optional extern berechnet und in einem zweiten Speicherbereich des Füllstandsmessgerät-Rechners bereitgestellt werden. Dies ermöglicht eine externe Berechnung insbesondere dann, wenn die Gleitkommazahl für verschiedene Messwerte innerhalb eines Messgerätes oder einer Messreihe konstant ist, so dass eine Umsetzung nicht innerhalb des Füllstandsmessgerät-Rechners erfolgen muss und dieser einfacher ausgestaltet sein kann.

Die Multiplikation kann durchgeführt werden, indem in einer Schleife mehrfach der Wert einer Summe mit dem Wert der Basis des Exponenten multipliziert wird und, falls ein entsprechendes Bit der Mantisse der zweiten ganzen Zahl ungleich Null ist, auf die Summe der Wert der ersten ganzen Zahl addiert wird, wobei die Wertigkeit des Bits der zweiten ganzen Zahl ($x_m$), welches je Schleife beachtet wird, von Schleife zu Schleife geringer wird. Dabei wird bevorzugt abschließend als das Ergebnis der Multiplikation der Wert der Summe dividiert durch die Zweierpotenz der Anzahl der Schleifendurchläufe und zuletzt erhöht um den Wert des Rundungsbits mit insbesondere dem Wert 0 oder 1 gesetzt. Insbesondere wird abschließend als das Ergebnis der Multiplikation der Wert der Summe, von der zuvor durch eine Division durch eine Zweierpotenz Bits verworfen wurden und zu der zuletzt der Wert eines Rundungsbits addiert wurde, das dem höchstwertigen der durch die Division durch die Zweierpotenz zuvor verworfenen Bits entspricht, gesetzt.

Auf einem Rechner, insbesondere auf einem Mikrorechner mit einem sehr kleinem Speicher kann so eine ganz Zahl, z.B. 89, mit einer Gleitkommazahl, z.B. 1,2288, multipliziert werden und als Ergebnis wieder eine ganze Zahl entstehen, z.B. 109. Diese Operation ist z.B. vorteilhaft, wenn in einem Füllstandsmessgerät ein gemessener Rohwert mit einem Faktor zu multiplizieren ist, um einen genauen Messwert zu erhalten. Dabei müssen keine Rechenoperationen für Gleitkommazahlen und keine Multiplikation und keine Division für ganze Zahlen verwendet werden, so dass der Mikrorechner diese Rechenoperationen nicht im Befehlssatz eingebaut haben muss und sie auch nicht als Bibliotheksfunktionen aufgerufen werden müssen. Bibliotheksfunktionen, welche viele Befehle des Befehlssatzes des Mikrorechners benötigen und deshalb erstens viel Speicher, der auf dem Mikrorechner nicht zur Verfügung steht, und zweitens viel Rechenzeit verbrauchen, was einen erhöhten Strombedarf bedeutet, sind daher nicht notwendig. Daher kann der Mikrorechner in dieser Zeit auch einen Stromspar-Modus benutzen.

Außerdem bleibt die Rechenzeit sehr klein und die maximale Geschwindigkeit des Mikrorechners bzw. Taktfrequenz muss aus technischen Gründen nicht erhöht werden. Einsetzbar sind somit der Bauteile des Mikrorechners mit geringen Anforderungen an deren Grenzwerte und der Strombedarf ist direkt abhängig von einer nur geringen Taktfrequenz. Hervorzuheben sind ein sehr geringer Programmspeicherbedarf, sehr wenig Rechenzeit und damit optional ein sehr geringer Strombedarf.

Ein Ausführungsbeispiel wird nachfolgend anhand der Zeichnung näher erläutert. Es zeigen:

Fig. 1      ein Ablaufdiagramm einer ersten bevorzugten Verfahrensweise zum Durchführen einer Multiplikation einer ganzen Zahl mit einer Gleitkommazahl in einem Füllstands-Messgerät;

Fig. 2a     einen alternativen Algorithmus gemäß einer modifizierten Ausführungsform;

Fig. 2b     einen weiteren alternativen Algorithmus gemäß einer modifizierten Ausführungsform;

Fig. 3      beispielhaft Komponenten eines Messgerätes zur Verarbeitung eines Messwerts;

Fig. 4      eine alternative Ausgestaltung von Komponenten eines derartigen Messgeräts und

Fig. 5      eine noch weitere Ausführungsform mit weiteren Modifikationen der Komponenten zur Verarbeitung eines Messwerts.

Fig. 6      eine bekannte Kodierung einer Gleitkommazahl im IEEE-754 32-Bit Floating-Point-Format.

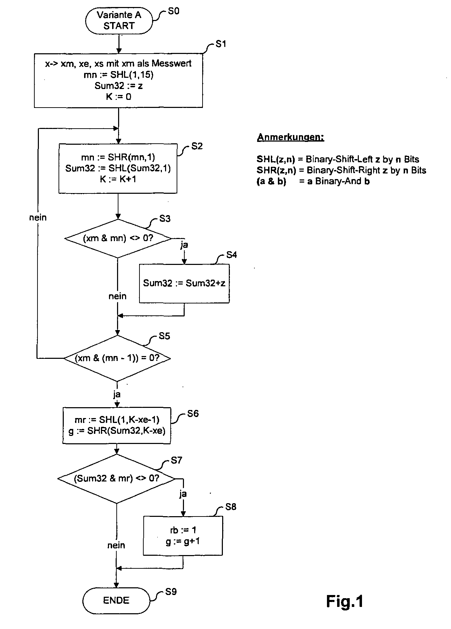

Fig. 1 zeigt einen Algorithmus, der in einem Mikrorechner mit einer 32-Bit-Summe Sum32 arbeitet und alle Glieder der Summe Sum32 berechnet, um eine erste ganze Zahl z und eine zu einer binären zweiten ganzen Zahl xm und einem Exponenten xe und einem Vorzeichen xs umgewandelte Gleitkommazahl x zu multiplizieren und ein ganzzahliges Ergebnis g auszugeben.

Nach einem Start S0 des Algorithmus werden in einem ersten Schritt S1 Variablen und Speicherbereiche vorbelegt. Dabei wird ein der Gleitkommazahl x entsprechender Wert xm und zugehörig ein Exponent xe und ein Vorzeichen xs eingesetzt. Das Einsetzen erfolgt in Form der binären zweiten ganzen Zahl xm zusammen mit dem Exponenten xe ebenfalls in der Form einer binären ganzen Zahl und dem Vorzeichen xs in der Form eines Wahrheitswertes. Dazu wird entweder die Umwandlung der Gleitkommazahl x zu der binären zweiten ganzen Zahl xm mit zugehörigem Exponenten xe und dem Vorzeichen xs in dem Mikrorechner selber durchgeführt oder die entsprechende zweite ganze Zahl xm mit zugehörigem Exponenten xe und dem Vorzeichen xs von einem externen Rechner zugeführt und in einen entsprechenden Speicherbereich eingegeben. Außerdem wird ein weiterer Speicherbereich mit dem Wert der ersten ganzen Zahl z belegt, wobei auch in diesem Speicherbereich die ganze Zahl z wieder als eine binäre Zahl gespeichert wird. Des weiteren wird eine Mantissen-Maske mn in einem Speicher mit dem Bitwert des der zweiten ganzen Zahl xm entsprechenden höchsten Bits vorbelegt. Für nachfolgende Berechnungsschritte werden außerdem eine Summe Sum32 mit dem Wert der ersten ganzen Zahl z und eine Variable für eine Anzahl K der von Schleifendurchläufen mit dem Wert "0" belegt.

Nachfolgend wird eine Berechnungsschleife eingeleitet, in welcher in einem zweiten Verfahrensschritt S2 die Bits der Mantissen-Maske mn um ein Bit nach rechts verschoben werden, was in den Figuren als Operation SHR gekennzeichnet ist, um den zu prüfenden Bitwert der Mantisse xm für weitere Schritte bereitzustellen. Außerdem werden die Bits in dem Speicherbereich für die Summe Sum32 um ein Bit nach links verschoben, was in den Figuren als Operation SHL gekennzeichnet ist. Die Variable für die Anzahl K der Schleifendurchläufe wird um den Wert "1" erhöht.

In einem nachfolgenden dritten Verfahrensschritt S3 wird geprüft, ob der Wert der Mantisse xm mit ihrem nun aktuell zu betrachtenden Bit ungleich Null ist. Dies kann geschehen, indem man das Ergebnis einer bitweisen Und-Verknüpfung bzw. Operation & zwischen der Mantisse xm und der der Mantissen-Maske mn betrachtet. Falls ja, wird in einem vierten Verfahrensschritt S4 der Wert der Summe Sum32 um den Wert der ersten ganzen Zahl erhöht bzw. die erste ganze Zahl addiert. In einem nachfolgenden fünften Schritt S5 wird eine Abfrage durchgeführt, ob alle nachfolgenden Bits der Mantisse xm bzw. Koeffizienten gleich Null sind. Falls beim dritten Verfahrensschritt S3 festgestellt wird, dass das zu betrachtenden Bit der Mantisse xm gleich Null ist, wird gleich zu dem fünften Verfahrensschritt fortgeschritten.

Falls bei dem fünften Verfahrensschritt S5 festgestellt wird, dass noch nachfolgende Bits der Mantisse xm ungleich Null sind, wird zum zweiten Verfahrensschritt zurückgegangen. Mit anderen Worten wird die derart gebildete Schleife so oft durchgeführt, bis festgestellt wird, dass alle weiteren Additionsschritte lediglich zu einer Addition eines Nullwertes führen würden. Außerdem endet die Schleife vorzugsweise spätestens nach K = p-1 Durchläufen, wenn die Mantisse xm mit p Bits Genauigkeit gespeichert wird, da dann durch mehrfache Bitverschiebungen der Mantissen-Maske mn nach rechts diese den Wert 1 hat und deshalb (mn - 1) gleich Null wurde und somit gleichzeitig das Ergebnis der binären Und-Verknüpfung von xm und (mn - 1) gleich Null wurde.

Falls die Schleife in dem fünften Verfahrensschritt S5 abgeschlossen wird, wird zu einem sechsten Verfahrensschritt S6 fortgeschritten. In diesem wird eine Bitmaske mr für das Rundungs-Bit rb belegt mit dem Wert, welcher sich ergibt, wenn man eine Linksverschiebung SHL der Zahl 1 um die Anzahl K der Schleifendurchläufe minus 1 durchführt. Das gesetzte Bit in der Bitmaske mr entspricht dann dem höchstwertigen Bit, das bei einer Rechtsverschiebung der Summe Sum32 um Anzahl K der Schleifendurchläufe verworfen wird.. Außerdem wird eine Rechtsverschiebung SHR als logische Verschiebung der Bits in dem Speicherbereich für die Summe Sum32 um die Anzahl K der Schleifendurchläufe vorgenommen und der resultierende Wert als das vorläufige Ergebnis g festgesetzt.

In einem nachfolgenden siebten Schritt S7 wird geprüft, ob das Ergebnis einer binären Und-Verknüpfung der Summe Sum32 mit der Bitmaske mr ungleich Null ist. Ist das der Bitmaske mr entsprechende Bit der Summe Sum32 gesetzt, so muss aufgerundet werden. Falls ja, wird in einem achten Verfahrensschritt S8 das Rundungs-Bit rb = 1 und deshalb der Wert des Ergebnisses g um "1" erhöht. Nachfolgend wird der Algorithmus beendet mit S9, was andernfalls direkt geschieht, falls bei der Abfrage im siebten Verfahrensschritt S7 festgestellt wird, dass das Ergebnis der Und-Verknüpfung gleich Null ist.

Mathematisch lässt sich die Verfahrensweise beschreiben durch folgende Zusammenhänge. Wenn eine ganze Zahl z mit einer Gleitkommazahl x multipliziert wird und als Produkt die ganze Zahl g als Ergebnis g erhalten werden soll, so kann nach einer Näherungsgleichung für Gleitkommazahlen, wie sie z.B. für das IEEE-754 Floating-Point-Format verwendet wird, folgende Näherungsformel aufgestellt werden

$$g = z \cdot x \approx z \cdot (-1)^s \cdot 2^e \left( m_0 + m_1 2^{-1} + m_2 2^{-2} + m_3 2^{-3} + \ldots + m_p 2^{-p} \right)$$

$$= z \cdot (-1)^s \cdot 2^e \sum_0^p m_n 2^{-n} \; .$$

Diese Näherungsformel lässt sich umformen zu

$$g = z \cdot x \approx (-1)^s \cdot 2^e \left( z \cdot m_0 + z \cdot m_1 2^{-1} + z \cdot m_2 2^{-2} + z \cdot m_3 2^{-3} + \ldots + z \cdot m_p 2^{-p} \right)$$

$$= (-1)^s \cdot 2^e \sum_0^p z \cdot m_n 2^{-n} \, .$$

In einem weiteren Schritt kann die Reihe durch Multiplikation jedes Summenglieds mit $2^p$ und anschließende Division der Summe durch $2^p$ vereinfacht werden zu

$$g = z \cdot x \approx \frac{(-1)^s \cdot 2^e \cdot \left( z \cdot m_0 2^p + z \cdot m_1 2^{p-1} + z \cdot m_2 2^{p-2} + z \cdot m_3 2^{p-3} + \ldots + z \cdot m_p 2^{p-p} \right)}{2^p} \, .$$

bzw., da $2^{p-p} = 2^0 = 1$ gilt noch einfacher zu

$$g = z \cdot x \approx (-1)^s \cdot \frac{2^e}{2^p} \cdot \left( z \cdot m_0 2^p + z \cdot m_1 2^{p-1} + z \cdot m_2 2^{p-2} + z \cdot m_3 2^{p-3} + \ldots + z \cdot m_p \right),$$

wobei dies nicht in der Summenformel-Schreibweise erfolgt.

Nun befinden sich in den Elementen der Reihe nur noch Werte, die den Wert 0 oder $z \cdot 2^n$ ($n \geq 0$) haben können, da ja die Koeffizienten der Mantisse $m_0 .. m_p$ nur 0 oder 1 sein können. Das bedeutet, dass eine Summe von Gliedern $z \times 2^n$ erhalten wird. Vorteilhaft ausnutzbar ist dabei, dass die Rechenoperation $z \times 2^n$ für eine beliebige ganze Zahl $z$ in der Binärdarstellung, wie sie in Mikrorechnern üblicherweise verarbeitet wird, durch n-fache Multiplikation mit 2 erreicht werden kann, wobei die n-fache Multiplikation mit 2 einer Linksverschiebung um n Bits entspricht.

Da die Summenreihe ein Polynom zur Basis 2 darstellt, kann entsprechend dem folgenden allgemeinem Beispiel für ein Polynom das Horner-Schema angewendet werden, nach dem gilt

$$y = a_n x^n + a_{n-1} x^{n-1} + \ldots + a_1 x^1 + a_0 = \left( .. \left( \left( a_n \cdot x + a_{n-1} \right) \cdot x + a_{n-2} \right) \cdot x + \ldots \right) \cdot x + a_1 \right) \cdot x + a_0 \, .$$

Damit wird eine noch viel einfachere und für Rechenvorgänge optimierte Näherungsformel erhalten in der Form

$$g = z \cdot x \approx (-1)^s \cdot \frac{2^e}{2^p} \cdot \left( \left( ( .. \left( \left( z \cdot m_0 \cdot 2 + z \cdot m_1 \right) \cdot 2 + z \cdot m_2 \right) \cdot 2 + \ldots \right) \cdot 2 + z \cdot m_{p-1} \right) \cdot 2 + z \cdot m_p \right)$$

In dieser Schreibweise für die Summe ist erkennbar, dass für jede Klammer-Ebene nur der Wert von $z$ hinzuaddiert werden muss, wenn der Koeffizient der Mantisse $m_n = 1$ ist und anschließend die neue Summe mit 2 multipliziert werden muss, wobei die Multiplikation einer einfachen Linksverschiebung um 1 Bit entspricht.

Damit vereinfacht sich die ganze Berechnung auf zwei einfache Operationen, die jeder Mikrorechner mit einem Maschinenbefehl direkt ausführen kann und die in einer Programmschleife p mal wiederholt werden. Zu Beachten ist dabei, dass die Summenbildung mit vergrößerter Bit-Anzahl, d.h. Datenwortlänge, durchzuführen ist, da sonst ein ganze Zahl-Überlauf auftreten würde. Dadurch ergibt sich als Datenwortlänge $d = w + p$, wenn w die Datenwortlänge von z ist.

Nach Bildung der Summe Sum32 wird diese Summe Sum32 nur noch durch $2^{p-e}$ dividiert, was einer Rechtsverschiebung um p-e Bits entspricht.

War das Vorzeichenbit von x gesetzt, d.h. S = 1, so wird der entstandene Wert noch negiert. Das Vorzeichen von z wird bei Verwendung der Zweierkomplementdarstellung für ganze Zahlen in der Summe schon berücksichtigt, d.h. wenn z < 0 ist, dann entsteht eine negative Summe. Bei der Verwendung vorzeichenbehafteter Zahlen für z wird bevorzugt darauf geachtet, dass bei der Addition auf den Summenspeicher, wenn dieser eine höhere Wortbreite als z hat, z.B. 32 statt 16 Bits, eine korrekte Vorzeichen-Erweiterung von z auf den oberen Bits erfolgt und außerdem werden Schiebe-Operationen für die Multiplikation/Division mit bzw. durch 2 verwendet, die dass Vorzeichenbit erhalten, was mit einer sogenannten arithmetic-shift umsetzbar ist. Für technische Anwendungen genügt oft die Verwendung vorzeichenloser Zahlen für z, so dass dort das Vorzeichenbit, da bei z nicht vorhanden, nicht beachtet werden muss und bei x ignoriert werden kann. Alternativ kann das Vorzeichen auch in einem eigenen Speicher gespeichert werden, um die Verarbeitung vorzeichenlos durchzuführen und das Vorzeichen abschließend wieder hinzuzufügen.

Das Ergebnis ist das Produkt g = z × x als ganze Zahl, wobei die dabei verlorengehenden zuvor ganz rechts stehenden p - e Bits binäre Nachkommastellen sind und optional weiterverwendet werden können.

Ist die ganze Zahl z positiv und liegt der Faktor x im Intervall 1 <= z < 2, d.h. das Vorzeichen ist s = 0 und der Exponent e = 0 ist und damit $2^e = 1$, so ergibt sich eine weitere Vereinfachung, da die Summe zum Schluss nur noch durch $2^p$ zu dividieren ist. Dies entspricht einer Rechtsverschiebung um p Bits. In diesem Fall kann die Vorzeichenbearbeitung entfallen.

In technischen Anwendung ist eine Wortbreite von 16 Bit für die ganze Zahl z üblicherweise ausreichend. Außerdem ist es üblicherweise wenig sinnvoll, wenn die Mantisse M des Faktors x mit höherer Genauigkeit als die ganze Zahl z gespeichert wird. Also kann mit 16 Bit für jeweils die ganze Zahl z und die Mantisse M des Faktors x gearbeitet werden. D.h. die Präzision p bzw. Genauigkeit beträgt p = 15 und es wird die Summe Sum32 erhalten, welche maximal 32 Bit groß ist. Liegt die Mantisse des Faktors x mit einer höheren Präzision p1 als die zu Verwendende p vor, so werden entsprechend vom höchstwertigen Bit bzw. MSB abwärts aus der Mantisse p Bits entnommen und die nachfolgenden Bits verworfen. War dabei das höchste der verworfenen Bits 1, so muss aufgerundet werden, indem die verwendete Mantisse um 1 erhöht wird, wenn die gewünschte Genauigkeit dies erfordert.

Mit einer solchen Verfahrensweise kann eine ganze Zahl, z.B. 89, mit einer Gleitkommazahl, z.B. 1,2288 multipliziert werden. Als Ergebnis g müsste dazu als ganze Zahl der Wert g = 109 entstehen.

Entsprechend dem zweiten Schritt S2 werden die zu multiplizierenden Zahlen z und x in Binärdarstellung mit beispielsweise der Wortbreite von 16 Bit in entsprechenden Registern oder Speicherbereichen 40, 41 bereitgestellt.

Die Darstellung der zu multiplizierenden Zahlen z und x entspricht somit gemäß nachfolgender Tabelle

| Zahl | Sedezimalcode | Binärcode |
|---|---|---|
| z = 89 | $0059_{16}$ | $0000\ 0000\ 0101\ 1001_2$ |
| x = 1,2288 | $9d49_{16}$ (Mantisse) | $1001\ 1101\ 0100\ 1001_2$ |

mit $1,2288 \approx 2^0 + 2^{-3} + 2^{-4} + 2^{-5} + 2^{-7} + 2^{-9} + 2^{-12} + 2^{-15} = 1,22879028$. Die Schreibweise $100_2$ bedeutet im Binärcode 100 zur Basis 2 = 4 dezimal und die Schreibweise $0100_{16}$ bedeutet im Sedezimalcode entsprechend 100 zur Basis 16 = 256 dezimal.

Durchführung der Multiplikation nach der vorstehend hergeleiteten optimierten Näherungsformel g = z × x ergibt

$$g \approx 2^{-15} \times (((((((((((((((89 \cdot 2+0)2+0)2+89)2+89)2+89)+0)2+89)2+0)2+89)2+0)2+0)2+89)2+0)2+0)2+89).$$

In Tabellendarstellung ergeben sich folgende Zwischenwerte:

| n | Koeff. $m_n$ von xm | Letzte Summe $+m_n \times z$ | Neue Summe $\times 2$ |
|---|---|---|---|
| 0 | 1 | 89 | 178 |
| 1 | 0 | 178 | 356 |
| 2 | 0 | 356 | 712 |
| 3 | 1 | 801 | 1602 |
| 4 | 1 | 1691 | 3382 |
| 5 | 1 | 3471 | 6942 |
| 6 | 0 | 6942 | 13884 |
| 7 | 1 | 13973 | 27946 |
| 8 | 0 | 27946 | 55892 |
| 9 | 1 | 55981 | 111962 |
| 10 | 0 | 111962 | 223924 |
| 11 | 0 | 223924 | 447848 |
| 12 | 1 | 447937 | 895874 |
| 13 | 0 | 895874 | 1791748 |
| 14 | 0 | 1791748 | 3583496 |
| 15 | 1 | 3583585 | |

Das letzte Glied wird optional nicht mehr multipliziert.

Das Ergebnis der Summe ist 3583585 dezimal = 0000 0000 0011 0110 1010 1110 0110 $0001_2$. Zur Verbesserung der Lesbarkeit wurden die Ziffern (Bits) im Binärcode (Basis 2) in Gruppen zu je 4 Bits geschrieben. Eine Gruppe von 4 Bit entspricht dann einer Ziffer im Sedezimalcode (Basis 16). Nach Division durch $2^{15}$ bzw. die Rechtsverschiebung um 15 Bits folgt 0000 0000 0110 1101[0101 1100 1100 $0010]_2$ bzw. $006d[5cc2]_{16}$ oder 109 dezimal. Die Ziffern zwischen [und] im Binär- und Sedezimalcode sind die durch die Rechtsverschiebung entfallenden Nachkommastellen. Bei den Nachkomma-Bits im Binärcode wurde ein abschließendes Bit mit 0 angehängt, was man ja darf, ohne den Wert zu ändern. In der Praxis ist dieses Bit in einem Schieberegister, bei dem die rechts herausgeschobenen Bits in einem weiteren Register aufgefangen werden, auch so vorhanden.

Optional kann das letzte Glied auch noch mit 2 multipliziert werden, wobei es dann statt durch $2^{15}$ durch $2^{16}$ dividiert wird entsprechend erst einer Rechtsverschiebung um 16 Bits ohne das Ergebnis zu verändern.

Bei vielen Mikrorechnern ist diese Vorgehensweise vorteilhaft, da dann nur die oberen 16 Bits übernommen werden müssen und die unteren 16 Bits einfach verworfen werden können. Dies kann z.B. geschehen, indem man nur die oberen 16 Bits des Ergebnis-Speichers ausliest.

Für diesen Fall ist die Summe 7167170 dezimal = 0000 0000 0110 1101 0101 1100 1100 $0010_2$. Nach Division durch $2^{16}$ bzw. eine Rechtsverschiebung um 16 Bits erhält man 0000 0000 0110 1101.0101 1100 1100 $0010_2$ bzw. $006d5cc2_{16}$ oder 109 dezimal.

Das 1. Bit nach dem Komma hat ja die Wertigkeit $2^{-1} = 1/2 = 0,5$ und entscheidet, ob aufgerundet wird. Alle nachfolgenden Bits ergeben in der Summe maximal 0,4999..., führen also nicht zur Aufrundung. Dies gilt so, da der Grenzwert der Summe über $2^{-n}$ für $n \rightarrow \infty$ gleich 2 ist und die Glieder $2^0$ und $2^{-1}$ zusammen schon 1,5 ergeben, so dass der Rest kleiner als 0,5 ist, da n maximal p und damit endlich ist.

Da bei dem dargestellten Beispiel das 1. Bit nach dem Komma nach der Rechtsverschiebung 0 ist, wird nicht aufgerundet. Es folgt als das Ergebnis g der Multiplikation $g = z \times x = 89 \times 1,2288 \approx 109$.

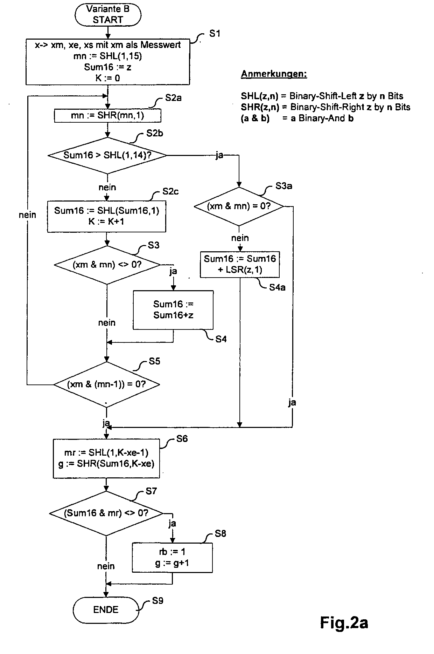

Fig. 2a zeigt als weitere beispielhafte Implementierung des Verfahrens als Flussdiagramm einen Algorithmus, der mit einer 16-Bit-Summe arbeitet und nur so lange rechnet, wie der 16-Bit-Wertebereich ausreicht. Zur Vereinfachung wird dabei der erlaubte Wertebereich für die erste Ganzzahl z auf +32767 beschränkt. Dafür wird aber bei Bedarf das nächste Summenglied noch mit einem Faktor 1/2 dazuaddiert, was einer 4/5-Rundungentspricht, und entsprechend durch ein $2^n$ mit kleinerem n dividiert, was einer geringeren Verschiebung entspricht.

Die Genauigkeit dieses zweiten Algorithmus reicht für technische Anwendungen in der Regel aus. Er ist noch schneller und braucht bei Mikrorechnern nur eine Wortbreite kleiner 32 Bit und somit auch weniger Programmspeicher und Datenspeicher.

Der zweite Algorithmus unterscheidet sich vom Ablauf im ersten Algorithmus gemäß Fig. 1 lediglich durch Verfahrensschritte im Bereich der Schleife sowie dadurch, dass eine Reduzierung des Speicherbereichs für die einzelnen Werte auf 16 Bits vorgenommen wird. Der Summenspeicher bzw. die Summe Sum32 wird deshalb durch einen Summenspeicher für die kleinere maximale Summe Sum16 mit 16 Bits Wortbreite ersetzt. Nachfolgend beschrieben werden daher nur Verfahrensschritte, welche sich von denen des Ablaufdiagramms gemäß Fig. 1 unterscheiden.

Der zweite Verfahrensschritt ist in drei Unterschritte untergliedert. In einem ersten Unterschritt des zweiten Verfahrensschrittes S2a wird die Mantissen-Maske mn bzw. deren Darstellung in einem Speicherbereich mit einer logischen Verschiebung nach rechts um 1 Bit verschoben.

Danach wird in einem zweiten Unterschritt des zweiten Verfahrensschritts S2b geprüft, ob die Summe Sum16 schon größer als ein Viertel des erlaubten Wertebereiches der Summe Sum16 ist, weil dann bei erneuter Linksverschiebung, x2 entsprechend, und anschließender Addition ein Überlauf auftreten könnte. Falls nein, folgen weitere Verfahrensschritte S2c, S3, S4, S5, welche den verbleibenden Unterschritten des zweiten Verfahrensschritts S2 und den dritten bis fünften Verfahrensschritten S3 - S5 des Algorithmus gemäß Fig. 1 entsprechen. Falls in dem zweiten Unterschritt des zweiten Verfahrensschrittes S2b festgestellt wird, dass die Summe größer ist, wird eine weitere Abfrage S3a durchgeführt, in welcher geprüft wird, ob das gerade untersuchte Bit der Mantisse xm gleich Null ist. Falls ja, wird direkt zum sechsten Verfahrensschritt S6 fortgeschritten. Falls nein, wird die Summe Sum16 neu gebildet durch den bisherigen Wert der Summe Sum16 plus dem Wert, welcher sich durch eine logische Rechtsverschiebung der ersten ganzen Zahl z um 1 Bit ergibt, was in einem Schritt S4a vergleichbar dem ursprünglichen vierten Schritt geschieht. Dies entspricht einer Addition der Hälfte der ersten ganzen Zahl z zu Sum16. Danach wird zu dem sechsten Verfahrensschritt S6 fortgeschritten.

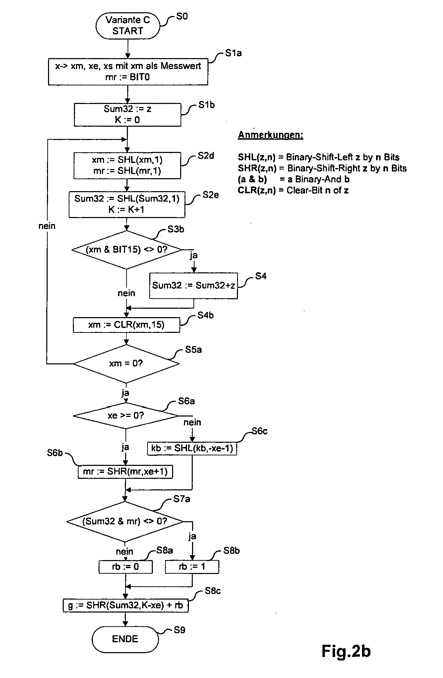

Die in anhand der Figuren 1 und 2a und 2b dargestellten Flussdiagramme stellen eine spezielle Untervariante des allgemeinen Verfahrens dar, da bei diesen Untervarianten der Rechenvorgang vorzeitig bei i = Anzahl der Schleifendurchäufe K endet, sobald alle weiteren Koeffizienten der Mantisse $m_i..m_p$ gleich 0 sind. Dieses vorzeitige Beenden der Ablauf- bzw. Programmschleife ist sinnvoll, da sonst ja nur noch der Wert 0 zur Summe addiert werden würde.

Wird im fünften Schritt S5 die Abfrage "(xm & (mn - 1)) <> 0?" jeweils ersetzt durch einen Test einer Zähl-Variable auf einen Endwert, z.B. "K < 16?" bei einer Mantisse mit 16 Bits, so wird die Rechenschleife durch ein Linksschieben und ggf. Addieren mit einer konstanter Anzahl von Schleifendurchläufen durchlaufen. Das vorzeitig endende Verfahren rechnet aber gleich genau und wird somit in der Regel schneller ausgeführt.

Vorteilhaft ist optional der Einsatz der Mantisse M von x als vorberechnete Konstante. Ist die Gleitkommazahl x als Faktor konstant, so können die Mantisse M als xm und der Exponent E als xe sowie das Vorzeichen S als xs auf einem anderen Mikrorechner, z.B. einem PC vorberechnet und als Konstanten im Programmspeicher des Mikrorechners abgelegt werden, auf dem die Multiplikation mit einer variablen ganzen Zahl z als dem Messwert erfolgen soll.

Besonders vorteilhaft ist eine technische Umsetzung des Verfahrensablaufs auf einem Mikrorechner mit einem Ganzzahl-Multiplikationsbefehl. Hat ein Mikrorechner einen Befehl für die Multiplikation zweier ganzer Zahlen g = z1 x z2, so kann auf diesem die Multiplikation einer ganzen Zahl mit einer Gleitkommazahl g = z × x angewendet werden, indem die Mantisse M der Gleitkommazahl x im IEEE-754 Floating-Point-Format als ganze Zahl xm interpretiert und mit der ganzen Zahl z multipliziert wird. Nach der Multiplikation werden nur noch entsprechend dem Exponent e und der Präzision p der Mantisse von x Bit(s) verworfen, und zwar p-e Bit(s).

Fig. 2b zeigt als weitere beispielhafte Implementierung des Verfahrens als Flussdiagramm einen Algorithmus, der die Bits in dem Speicherbereich für die Mantisse xm um ein Bit nach links verschiebt, was durch die Operation SHL skizziert ist, damit das zum Test relevante Bit immer auf der Stelle des MSB (most-significant-bit) bereitsteht, was Schritt S2d entspricht. Anstelle der Mantisse xm kann eine Kopie der Mantisse xm in einem weiteren Speicherbereich hinterlegt werden, wenn die Mantisse xm selbst nicht verändert werden darf. Es muss deshalb immer nur das MSB betrachtet werden, wenn entschieden wird, ob z erneut zur Summe Sum32 addiert werden soll, was Schritt S3b entspricht. Nach der Überprüfung des MSB wird diese gelöscht mit einer Lösch-Operation CLR, damit das MSB nicht mehr in der Mantisse xm enthalten ist, was Schritt S4b entspricht. Die Schleife endet in Schritt S5a, sobald die Mantisse xm NULL ist, d.h. getestete Bits gelöscht wurden und keine ungetesteten Bits mehr enthalten sind, weil alle nachfolgenden Bits der Mantisse xm NULL sind.

Für die Bestimmung des Rundungsbits rb wird bereits in einem einleitenden Schritt S1a eine Bitmaske mr erstellt und in einem ersten Schleifenschritt S2d aktualisiert, die dann nur noch nach der Schleife um den Exponenten xe durch Verschiebung mittels Operationen SHR bzw. SHL korrigiert werden muss, was in Schritten S6a-S6c durchgeführt wird. Mit dieser Bitmaske mr kann dann der Wert des Rundungsbits rb ermittelt werden, was in Schritten S7a, S8a, S8b durchgeführt wird. Zuletzt wird das Ergebnis g als die mittels der Operation SHR um K-e nach rechts geschobene Summe Sum32 erhöht um den Wert des Rundungsbits rb gesetzt.

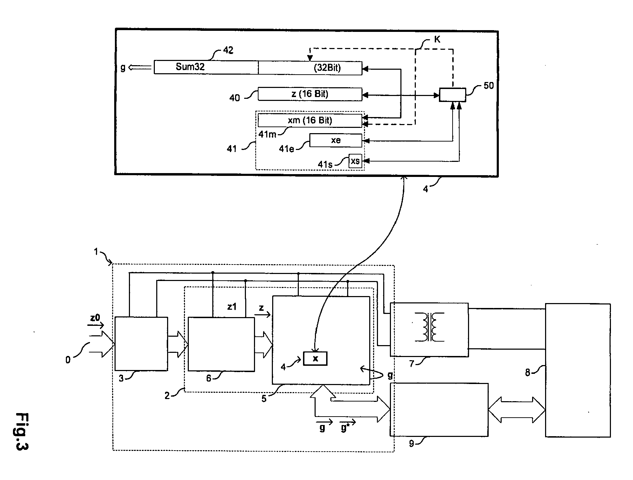

Fig. 3 zeigt Komponenten eines beispielhaften FüllstandsMessgeräts 1, welche zur Verarbeitung von Messwerten z0 ausgebildet und/oder angesteuert sind. Die Messwerte z0 werden an einem Messwerte-Eingang 0 angelegt. Beispielsweise handelt es sich bei dem Messwerte-Eingang um einen Sensor, welcher Füllstandsdaten erfasst. Eine Sensor-Elektronik 3 bereitet die Messwerte auf und legt sie an einen Rechner 2 an. Der beispielhaft dargestellte Rechner 2 ist vorzugsweise ein Mikrorechner, welcher ausgelegt ist, Daten mit geringst möglichem Hardware- und Software-Aufwand zu verarbeiten, so dass ein kostengünstiger und zugleich stromsparender Rechner 2 eingesetzt werden kann. Die von der Sensor-Elektronik 3 bereitgestellten Daten werden mittels eines Analog-Digital-Wandlers 6, welcher als Komponente des Rechners 2 ausgestaltet sein kann, in digitale Daten umgesetzt und als die ersten ganzen Zahlen z an einen Prozessor 5 angelegt. Vorzugsweise handelt es sich bei dem Prozessor 5 um einen Mikroprozessor mit nur kleinem Programmspeicher und geringem Stromverbrauch, welcher ohne Multiplikationsbefehl für Gleitkommazahlen ausgestaltet ist. Der Prozessor 5 umfasst vorzugsweise einen Speicher 4, welcher mit möglichst geringer Anzahl von Speicherplätzen ausgestaltet ist.

Von dem Prozessor 5 verarbeitete Daten werden als digitale Daten in Form des Ergebnisses g oder von g abhängige Ergebnisse g* an externe Einrichtungen und Komponenten ausgegeben. Dazu werden die digitalen Daten bzw. das jeweilige Ergebnis g oder von g abhängige Ergebnisse g* an eine Schnittstelle 9 angelegt, welche beispielsweise als Schnittstelle für eine Datenkommunikation mit Optokopplern ausgestaltet sein kann. Jedoch auch andere Arten von Schnittstellen sind einsetzbar. Die Schnittstelle 9 gibt die Daten als digitale Daten an eine externe Verarbeitungseinrichtung 8 aus, welche beispielsweise als ein weiterer Mikroprozessor, ein Feldgerät, ein Auswertegerät, ein Leitsystem, ein Mikrorechner oder ein Personalcomputer ausgestaltet sein kann.

Zur Stromversorgung bzw. Spannungsversorgung dient beispielsweise eine Spannungsquelle 7, welche als Spannungswandler ausgestaltet ist. Von einer externen Einrichtung, beispielsweise der externen Verarbeitungseinrichtung 8 kann so eine z.B. eigensichere Stromversorgung an die Spannungsquelle in Form des Spannungswandlers angelegt werden, um interne Komponenten des Füllstands-Messgerätes, wie die Sensorelektronik 3, den Analog-Digital-Wandler 6 und den Prozessor 5 mit Spannung bzw. Strom zu versorgen.

Die dargestellte Anordnung, insbesondere deren Prozessor 5 mit dem Speicher 4 sind ausgestaltet, mit möglichst geringem Aufwand und Stromverbrauch die erste ganze Zahl z mit einem Anpassungsfaktor in Form der Gleitkommazahl x zu multiplizieren. Dazu weist der Prozessor 5 eine Logik 50 mit einfachen Additionsbefehlen sowie der Möglichkeit der Durchführung von Schiebeoperationen in Registern oder logischen Verschiebeoperationen in einem Speicherbereich des Prozessors auf.

Der Speicher 4 umfasst insbesondere einen ersten Speicherbereich 40 zum Speichern der ersten ganzen Zahl, wobei der erste Speicherbereich 40 einen Speicherplatz zum Speichern von 16 Bits aufweist. Außerdem weist der Speicher 4 einen zweiten Speicherbereich 41m auf, der zum Speichern der zweiten ganzen Zahl xm ausgebildet ist und einen Speicherraum für 16 Bits zur Verfügung stellt. Des weiteren steht ein Speicherbereich 41e zum Speichern von 8 Bits des Exponenten und 41s zum Speichern von 1 Bit als Vorzeichen zur Verfügung. Zum Durchführen von Berechnungsoperationen dient ein Berechnungsspeicherbereich 42, welcher einen Wertebereich von 32 Bits bereitstellt. In diesen wird die Summe Sum32 gespeichert. Insbesondere der Berechnungsspeicher 42 ist vorteilhaft als ein Schieberegister ausgestaltet, so dass Multiplikationen bzw. Divisionen der eingespeicherten Zahl um jeweils den Wert der Basis der exponentiellen Zahl durch einfache Verschiebeoperationen um 1 Bit nach rechts bzw. links durchführen zu können. Anstelle eines Schieberegisters kann aber auch eine Recheneinheit des Prozessors 5 mit Schieberegister realisiert werden.

Zum Bereitstellen der ersten ganzen Zahl z und der zweiten ganzen Zahl xm ist die Logik 50 entsprechend ausgestattet, diese als binär kodierte Zahlen in den ersten bzw. dem zweiten Speicherbereich 40, 41m sowie 41e und 41s zu speichern. Optional kann insbesondere die zweite ganze Zahl jedoch auch von extern über die Schnittstelle 9 angelegt werden, um so die Umsetzung bzw. Umwandlung von der Gleitkommazahl x in die exponentielle Darstellung als ganze Zahl xm sowie dazugehörigen Exponenten xe und Vorzeichen xs von einem externen Rechner vornehmen zu lassen.

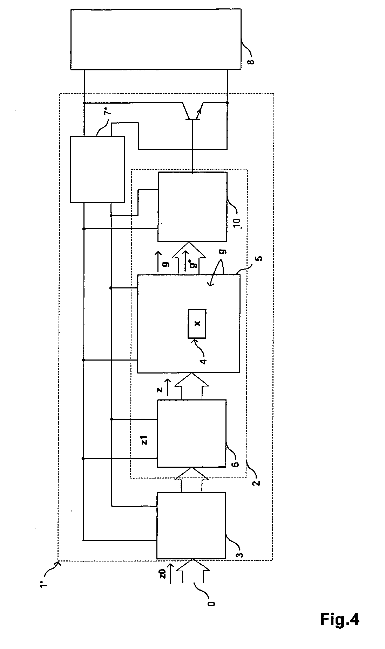

Fig. 4 zeigt eine Ausgestaltung von Komponenten eines alternativen Füllstands-Messgerätes 1*, wobei nachfolgend lediglich Unterschiede gegenüber der Ausführung gemäß Fig. 3 beschrieben werden. Bei dieser Ausgestaltung werden vom Prozessor 5 die ausgegebenen Zahlen bzw. Ergebnisse g oder von g abhängige Ergebnisse g* an einen Digital-Analog-Wandler 10 angelegt, welcher optional in den Prozessor 5 bzw. dem Rechner 2 integriert ist. Von dem Digital-Analog-Wandler werden entsprechend analoge Werte ausgegeben, welche einem Transistor angelegt werden. Dieser ist beispielsweise zwischen zwei Spannungsanschlüsse der Spannungsquelle 7 geschaltet, um so je nach Ansteuergrad des Transistors eine Stromsenke auszubilden und damit analoge Daten an die externe Verarbeitungseinrichtung 8 anzulegen. Die Spannungsquelle 7* versorgt wiederum Komponenten des Füllstands-Messgerätes 1*, vorliegend zusätzlich den Digital-Analog-Wandler 10 mit einer Betriebsspannung.

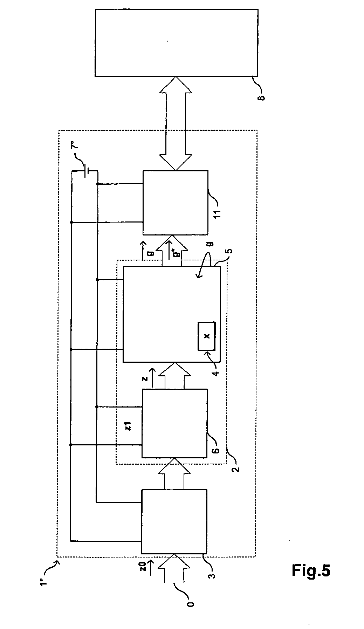

Fig. 5 zeigt Komponenten eines noch weiteren modifizierten Füllstands-Messgerätes 1°, wobei wieder nur Unterschiede gegenüber der Ausgestaltung gemäß Fig. 3 beschrieben werden. Bei dieser Ausgestaltung handelt es sich bei der Spannungsquelle 7° um eine Batterie, welche ein extern von sonstigen Versorgungseinrichtungen installiertes Füllstands-Messgerät 1° versorgt. Anstelle einer leitungsgebundenen oder optischen Schnittstelle ist ein Sendemodul 11 vorgesehen, welchem die digitalen Daten bzw. das Ergebnis g oder von g abhängige Ergebnisse g* angelegt werden, um entsprechend über ein Netzwerk, optische Verbindungen oder Funkverbindungen das Ergebnis und gegebenenfalls weitere digitale Daten zu einer externen Verarbeitungseinrichtung 8 zu kommunizieren.

**Patentansprüche**

1.  Verfahren zum Ansteuern eines Füllstandsmessgeräts mit

    - einem Messwerteingang (0) zum Anlegen eines Messwerts (z0),
    - zumindest einem ersten Speicherbereich (40) zum Bereitstellen eines Anpassungsfaktors und einem weiteren Speicherbereich zum Belegen mit dem Wert einer ersten ganzen Zahl (z) und
    - einem Mikrorechner (2) zur Multiplikation einer ganzen Zahl (z) mit einer Gleitkommazahl (x) zu einem Ergebnis (g) der Multiplikation, wobei
    - der weitere Speicherbereich mit der ersten ganze Zahl (z), welche einem am Messwerteingang (0) angelegten Messwert (z0) entsprichtbelegt wird und
    - in den ersten Speicherbereich (40) die Gleitkommazahl (x), welche dem Anpassungsfaktor entspricht, eingesetzt wird,
    **dadurch gekennzeichnet, dass**
    - die Gleitkommazahl (x) in Form einer binären zweiten ganzen Zahl (xm) zusammen mit einem Exponenten (xe) in Form einer binären ganzen Zahl und einem Vorzeichen (xs) in Form eines Wahrheitswertes eingesetzt wird, wozu entweder die Umwandlung der Gleitkommazahl (x) zu der binären zweiten ganzen Zahl (xm) mit zugehörigem Exponenten (xe) und dem Vorzeichen (xs) in dem Mikrorechner (2) selber durchgeführt wird oder die entsprechende zweite ganze Zahl (xm) mit zugehörigem Exponenten (xe) und dem Vorzeichen (xs)von einem externen Rechner zugeführt und in einen entsprechenden Speicherbereich eingegeben wird, und
    - eine Multiplikation der ersten ganzen Zahl (z) und der zweiten ganzen Zahl (xm) durchgeführt wird (S2-S5), um Sensor einflüsse oder Geräteeinflüsse beim Erfassen des Messwerts aus zugleichen,
    wobei keine Rechenoperation für Gleitkommazahlen und keine Division für ganze Zahlen verwendet werden, und das Ergebnis (g) als digitale Daten über eine Schnittstelle (9) an eine externe Verarbeitungs einrichtung (8) ausgegeben wird.

**2.** Verfahren nach Anspruch 1, bei dem eine von einer Präzision (p) der Mantisse (m) und von dem Exponenten (e) abhängige Anzahl von Stellen (p-e) ab der Position des LSBs des Multiplikationsergebnisses (g) nach der Multiplikation verworfen werden (S6).

**3.** Verfahren nach einem der Ansprüche 1_oder 2, bei dem zum Durchführen der Multiplikation wiederholt ein Addieren und eine bitweise Verschiebung eines Inhalts eines Berechnungsspeicherbereichs (42) oder ein dementsprechendes Auslesen des Inhalts des Berechnungsspeicherbereichs (42) durchgeführt wird.

**4.** Verfahren nach Anspruch 2, bei dem zum Multiplizieren ein Ganzzahl-Multiplikationsbefehl eines Rechners (2) durchgeführt wird, wobei eine Mantisse (M) der Gleitkommazahl (x), insbesondere der Gleitkommazahl (x) im IEEE-754 Floating-Point-Format, als ganze Zahl (xm) interpretiert und mit der ersten ganzen Zahl (z) multipliziert wird, woraufhin nach der Multiplikation entsprechend einem Exponenten (e) und einer Präzision (p) der Mantisse (p-e) Bits ab der Position des LSBs verworfen werden.

**5.** Verfahren nach Anspruch 2, bei dem eine Schleife aus Additionen und Verschiebungen vorzeitig nach einer Anzahl von K Schleifendurchläufen beendet wird, sobald alle weiteren Koeffizienten der Mantisse ($m_i..m_p$) gleich 0 sind, woraufhin nach der Multiplikation entsprechend einem Exponenten e und einer Präzision p der Mantisse K-e Bits Bits verworfen werden (S6), wobei die Anzahl K der Schleifendurchläufe maximal so groß wie die Präzision p ist.

**6.** Verfahren nach einem der Ansprüche 1 bis 5, bei dem die Multiplikation durchgeführt wird, indem in einer Schleife (S2-S5) der Wert einer Summe (Sum32) mit dem Wert der Basis (2) des Exponenten (e) multipliziert wird (S2) und, falls ein entsprechendes Bit der Mantisse, insbesondere das einem Schleifendurchlauf entsprechende Bit der zweiten ganzen Zahl (xm) ungleich Null ist (S3), auf Summe (Sum32) der Wert der ersten ganzen Zahl (z) addiert wird (S4), wobei die Wertigkeit des Bits der zweiten ganzen Zahl (xm), welches je Schleife beachtet wird, von Schleife zu Schleife geringer wird.

**Claims**

**1.** A method of actuating a filling level gauge with

- a measurement value input (0) for creating a measurement value (z0),
- at least one first memory area (40) for producing an adjustment factor and a further memory area to have allocated thereto the value of a first integral number (z) and
- a microcomputer (2) for the multiplication of an integral number (z) with a floating point number (x) to produce a result (g) of the multiplication, wherein
- the further memory area has allocated to it the first integral number (z), which corresponds to a measurement value (z0) created at the measurement value input (0), and
- the floating point number (x), which corresponds to [the] adjustment factor, is entered in the first memory area (40),
**characterized in that**
- the floating point number (x) in the form of a binary second integral number (xm) is entered together with an exponent (xe) in the form of a binary integral number and a sign (xs) in the form of a logical value, to which end either the conversion of the floating point number (x) to form the binary second integral number (xm) with the associated exponent (xe) and the sign (xs) is carried out in the microcomputer (2) itself or the corresponding second integral number (xm) with the associated exponent (xe) and the sign (xs) is supplied from an external computer and is entered in a corresponding memory area, and
- a multiplication of the first integral number (z) and the second integral number (xm) is carried out (S2 - S5), in order to compensate influences of sensors or gauges during the detection of the measurement value, wherein no calculation operation for floating point numbers and no division for integral numbers are used, and

the result (g) is supplied as digital data by way of an interface (9) to an external processing device (8).

**2.** A method according to claim 1, in which a number of locations (p - e) dependent upon a precision (p) of the mantissa (m) and upon the exponent (e) are discarded from the position of the LSB of the multiplication result (g) after the multiplication (S6) .

**3.** A method according to one of claims 1 or 2, in which in order to carry out the multiplication an addition and a bit-wise shift of the content of a calculation memory area (42) or a corresponding reading out of the content of the calculation memory area (42) is carried out repeatedly.

4. A method according to claim 2, in which an integral number multiplication command of a computer (2) is carried out for the multiplication, wherein a mantissa (M) of the floating point number (x), in particular the floating point number (x) in the IEEE-754 Floating Point Format, is interpreted as an integral number (xm) and is multiplied with the first integral number (z), after which bits are discarded from the position of the LSB after the multiplication in accordance with an exponent (e) and a precision (p) of the mantissa (p - e).

5. A method according to claim 2, in which a loop of additions and shifts is terminated ahead of time after a number of K loop runs, as soon as all further coefficients of the mantissa ($m_i$ ... $m_p$) are equal to 0, after which bits are discarded after the multiplication in accordance with an exponent e and a precision p of the mantissa K-e bits (S6), wherein the number K of the loop runs is at most as great as the precision p.

6. A method according to any one of claims 1 to 5, in which the multiplication is carried out by the value of a sum (Sum32) being multiplied with the value of the base (2) of the exponent (e) in a loop (S2 - S5) and, if a corresponding bit of the mantissa, in particular the bit of the second integral number (xm) corresponding to a loop run, is not equal to zero (S3), by the value of the first integral number (z) being added (S4) to the sum (Sum32), wherein the value of the bit of the second integral number (xm) which is taken into consideration per loop becomes smaller from loop to loop.

**Revendications**

1. Procédé de commande d'un appareil de mesure de niveau comportant :

   - une entrée de valeurs de mesure (0) pour appliquer une valeur de mesure (z0),
   - au moins une première zone de mémoire (40) pour préparer un facteur d'adaptation et une autre zone de mémoire ou seconde zone de mémoire pour introduire la valeur d'un premier nombre entier (z), et
   - un micro calculateur (2) pour multiplier un nombre entier (z) par un nombre à virgule flottante (x) pour obtenir un résultat (g) de multiplication, selon lequel
   - on introduit dans la seconde zone de mémoire le nombre entier (z) qui correspond à la valeur de mesure (z0) appliquée à l'entrée de valeurs de mesure (0), et
   - on insère dans la première zone de mémoire (40) le nombre à virgule flottante (x) qui correspond au facteur d'adaptation,
   **caractérisé en ce que** le
   - on insère le nombre à virgule flottante (x) sous la forme d'un second nombre entier binaire (xm) avec un exposant (xe) sous la forme d'un nomre entier binaire et un signe (xs) sous la forme d'une valeur de probabilité, et, pour ce, la transformation du nombre à virgule flottante (x) en le second nombre entier binaire (xm) avec l'exposant (xe) et le signe (xs) propres est effectuée dans le micro calculateur (2) lui-même, ou, le second nombre entier (xm) correspondant est transféré avec l'exposant (xe) et le signe (xs) propres par un calculateur externe et entré dans une zone de mémoire correspondante, et
   - on effectue une multiplication du premier nombre entier (z) et du second nombre entier (xm) (S2-S5), pour compenser des influences de capteurs ou d'appareillage lors de la détection de la valeur de mesure, aucune opération de calcul n'étant utilisée pour les nombres à virgule flottante et aucune division n'étant utilisée pour les nombre entier, et le résultat (g) étant délivré sous la forme de données numériques par l'intermédiaire d'une interface (9) à un dispositif de traitement externe (8).

2. Procédé conforme à la revendication 1, selon lequel on supprime un nombre de chiffres (p-e) dépendant de la précision (p) de la mantisse (m) et de l'exposant (e) à partir de la position du LSB du résultat de la multiplication (g) après la multiplication (S6).

3. Procédé conforme à l'une des revendications 1 ou 2, selon lequel pour effectuer la multiplication on effectue de façon répétitive une addition et un décalage par bit du contenu d'une zone de mémoire de calcul (42) ou une lecture correspondante du contenu de la zone de mémoire de calcul (42).

4. Procédé conforme à la revendication 2, selon lequel pour effectuer la multiplication on effectue une instruction de multiplication de nombre entier d'un calculateur (2), la mantisse (M) du nombre à virgule, flottante (x), en particulier du nombre à virgule flottante (x) dans le format *Floating-Point IEEE-754* étant interprétée en tant que nombre entier (xm) et multipliée par le premier nombre entier (z), et ensuite, après la multiplication, des bits étant supprimés à partir de la position du LSB en fonction de l'exposant (e) et de la précision (p) de la mantisse (p-e).

5. Procédé conforme à la revendication 2, selon lequel on termine prématurément une boucle d'additions et de décalages après un nombre K de déroulement de boucles dès que tous les autres coefficients de la mantisse ($m_i$ ... $m_p$) sont nuls, puis, après la multiplication on supprime K-e bits en fonction de l'exposant (e) et de la précision (p) de la mantisse (S6), le nombre K de déroulement de boucles étant au maximum égal à la précision (p).

6. Procédé conforme à l'une des revendications 1 à 5, selon lequel on effectue la multiplication en multipliant dans une boucle (S2-S5) la valeur d'une somme (Sum32) par la valeur de la base (2) de l'exposant (e) (S2) et si un bit correspondant de la mantisse en particulier le bit du second nombre entier (xm) correspondant au déroulement d'une boucle n'est pas égal à zéro (S3) on ajoute à la somme (Sum32) la valeur du premier nombre entier (z) (S4) le poids du bit du second nombre entier (xm) pris en considération pour chaque boucle devenant plus faible de boucle en boucle.

Fig.1

**Anmerkungen:**

SHL(z,n) = Binary-Shift-Left z by n Bits
SHR(z,n) = Binary-Shift-Right z by n Bits
(a & b)  = a Binary-And b

Variante B
START

S1

x-> xm, xe, xs mit xm als Messwert
mn := SHL(1,15)
Sum16 := z
K := 0

**Anmerkungen:**

SHL(z,n) = Binary-Shift-Left z by n Bits
SHR(z,n) = Binary-Shift-Right z by n Bits
(a & b)    = a Binary-And b

S2a

mn := SHR(mn,1)

S2b

Sum16 > SHL(1,14)?    ja

nein

S2c

Sum16 := SHL(Sum16,1)
K := K+1

S3a

(xm & mn) = 0?

nein

S3

(xm & mn) <> 0?
ja

Sum16 := Sum16
+ LSR(z,1)

S4a

nein

Sum16 :=
Sum16+z

S4

nein

S5

(xm & (mn-1)) = 0?

nein

ja

ja

S6

mr := SHL(1,K-xe-1)
g := SHR(Sum16,K-xe)

S7

(Sum16 & mr) <> 0?
ja

S8

rb := 1
g := g+1

nein

ENDE    S9

**Fig.2a**

16

**Fig.2b**

Fig.3

Fig.4

Fig.5

EP 2 189 897 B1

**Fig.6**

**IN DER BESCHREIBUNG AUFGEFÜHRTE DOKUMENTE**

**In der Beschreibung aufgeführte Patentdokumente**

- US 6233595 B1
- JP 61049234 A
- EP 0278529 A
- DE 102006013827 A1


**In der Beschreibung aufgeführte Nicht-Patentliteratur**

- **BEHROOZ PARHAMI.** Computer Arithmetic: Algorithms and Hardware Designs. Oxford University Press
- **G. MARTIN.** Application Insight Through Performance Modeling. *IPCC,* 20. April 2007, vol. 07, 64-74